# EUROPEAN PATENT SPECIFICATION

(11) **EP 4 354 163 B1**
(45) Date of publication and mention of the grant of the patent: **01.04.2026**
(21) Application number: 22881228.5
(22) Date of filing: 15.09.2022
(51) Int. Cl.: G01R 31/392, G01R 31/367, G01R 31/3842, H02J 7/00, G06N 20/00, G01R 31/36, G06N 5/01

(54) **BATTERY CHARGE AND DISCHARGE PROFILE ANALYSIS METHOD, AND BATTERY CHARGE AND DISCHARGE PROFILE ANALYSIS APPARATUS**
VERFAHREN ZUR ANALYSE DES BATTERIELADE- UND ENTLADEPROFILS SOWIE VORRICHTUNG ZUR ANALYSE DES BATTERIELADE- UND ENTLADEPROFILS
PROCÉDÉ ET DISPOSITIF D'ANALYSE DE PROFILS DE CHARGES ET DE DÉCHARGES DE BATTERIES

(30) Priority: 13.10.2021 KR 20210136161
(43) Date of publication of application: 17.04.2024
(73) Proprietor: LG Energy Solution, Ltd., Seoul 07335 (KR)
(72) Inventor: PARK, Do-Hyun, Daejeon 34122 (KR)
(74) Representative: Goddar, Heinz J.
(86) International application number: PCT/KR2022/013827
(87) International publication number: WO 2023/063599

(56) References cited:
- KR-A- 20090 020 362
- KR-A- 20130 113 296
- KR-A- 20160 097 029
- KR-A- 20200 140 093
- KR-A- 20210 063 965
- US-A1- 2016 301 243

## Description

### TECHNICAL FIELD

The present application claims the benefit of Korean Patent Application No. 10-2021-0136161 filed on October 13, 2021 with the Korean Intellectual Property Office.

The present disclosure relates to battery charge/discharge profile analysis, and more particularly, to technology that analyzes a charge/discharge profile monitored from a battery cell during an activation process based on the unique features of the steps of the activation process and automatically assigns section classification information corresponding to the steps of the activation process to the charge/discharge profile.

### BACKGROUND ART

Recently, there has been a rapid increase in the demand for portable electronic products such as laptop computers, video cameras and mobile phones, and with the development of electric vehicles, batteries for energy storage, robots and satellites, many studies are being made on high performance batteries that can be repeatedly recharged.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

A battery cell assembled into a completed product through a production line is finally released after it undergoes an activation process. In the activation process, a series of pre-scheduled charge/discharge control sections are performed in a sequential order by charging/discharging equipment, and accordingly, the capacity and performance of the battery cell are set to the design specification.

Additionally, the activation process is the last step of acquiring data for battery testing used to filter out a defective battery cell before a product release. Time-series data of various battery parameters (for example, voltage, current, capacity) acquired from the battery cell during the charge/discharge control sections of the activation process may be compared with preset reference condition(s) to associate it with some charge/discharge control sections to test whether the battery cell is faulty or not.

To this end, the conventional charging/discharging equipment may not normally perform the segmentation function of repeating the operation of allocating an identification number of the corresponding charge/discharge control section to the battery parameter during each charge/discharge control section of the activation process, and even when the identification number is allocated, more precise segmentation setting may be necessary to determine whether the product is good or bad using a physical identification section.

As described above, in case that section information is absent or suitable section information is not stored in data analysis aspect even though section information is present, it is difficult to extract features and diagnose and analyze the battery cell from the time-series data (the charge/discharge profile).

US 20160301243 A1 describes a method for battery charge profile synthesis.

### DISCLOSURE

### Technical Problem

The present disclosure is designed to solve the above-described problem, and therefore the present disclosure is directed to providing a method and apparatus for automatically allocating an identification number of each charge/discharge control section of an activation process for each sample value (data point) in time-series data of a charge/discharge profile acquired by monitoring battery parameters of a battery cell during the activation process.

These and other objectives and advantages of the present disclosure may be understood by the following description and will be apparent from an embodiment of the present disclosure. In addition, it will be readily understood that the objectives and advantages of the present disclosure may be realized by the means set forth in the appended claims and a combination thereof.

### Technical Solution

A battery charge/discharge profile analysis method according to an aspect of the present disclosure includes training a machine learning model using a plurality of training charge/discharge profiles as a training dataset, wherein each training charge/discharge profile includes training section classification information, and the training section classification information is a dataset in which an identification number of any one of a plurality of charge/discharge control sections performed in a sequential order in an activation process is allocated to each time index; inputting a target charge/discharge profile acquired through the activation process of a battery cell to the machine learning model; and acquiring target section classification information for the input target charge/discharge profile from the machine learning model. The target section classification information is a dataset in which the identification number of any one of the plurality of charge/discharge control sections is allocated to each time index of the target charge/discharge profile.

The target charge/discharge profile includes time-series voltage data indicating a time-dependent change of a voltage of the battery cell according to the time indexes of the target charge/discharge profile; and time-series current data indicating a time-dependent change of a charge/discharge current of the battery cell according to the time indexes of the target charge/discharge profile.

The machine learning model may be a decision tree.

The battery charge/discharge profile analysis method further includes determining if the target charge/discharge profile is abnormal by comparing the identification numbers allocated to the time indexes of the target section classification information according to a sequence of the time indexes of the target section classification information.

The identification number of a previous charge/discharge control section may be smaller than the identification number of a subsequent charge/discharge control section among any two of the plurality of charge/discharge control sections.

The step of determining if the target charge/discharge profile is abnormal may include determining that the target charge/discharge profile is abnormal when the identification number allocated to the previous time index is larger than the identification number allocated to the subsequent time index among any two time indexes of the target section classification information.

The step of determining if the target charge/discharge profile is abnormal may include determining that the target charge/discharge profile is abnormal when any of the plurality of identification numbers of the plurality of charge/discharge control sections has a value between two identification numbers allocated to any two adjacent time indexes of the target section classification information.

The step of determining if the target charge/discharge profile is abnormal may include determining that the target charge/discharge profile is abnormal when the identification number of at least one of the plurality of charge/discharge control sections is allocated to none of the time indexes of the target section classification information.

A battery charge/discharge profile analysis apparatus according to another aspect of the present disclosure includes a data acquisition unit configured to store a plurality of training charge/discharge profiles, wherein each training charge/discharge profile includes training section classification information and the training section classification information is a dataset in which an identification number of any one of a plurality of charge/discharge control sections performed in a sequential order in an activation process is allocated to each time index; and a data processing unit configured to train a machine learning model using the plurality of training charge/discharge profiles as a training dataset. The data processing unit is configured to input a target charge/discharge profile acquired through the activation process of a battery cell to the machine learning model, wherein the target charge/discharge profile includes time-series voltage data indicating a time-dependent change of a voltage of the battery cell according to the time indexes of the target charge/discharge profile, and time-series current data indicating a time-dependent change of a charge/discharge current of the battery cell according to the time indexes of the target charge/discharge profile; acquire target section classification information for the input target charge/discharge profile from the machine learning model. The target section classification information is a dataset in which the identification number of any one of the plurality of charge/discharge control sections is allocated to each of the time indexes of the target charge/discharge profile.

The machine learning model may be a decision tree.

The data processing unit is further configured to determine if the target charge/discharge profile is abnormal by comparing the identification numbers allocated to the time indexes of the target section classification information according to a sequence of the time indexes of the target section classification information.

A battery activation system according to still another aspect of the present disclosure includes the battery charge/discharge profile analysis apparatus.

### Advantageous Effects

According to at least one of the embodiments of the present disclosure, it is possible to automatically allocate the identification number of each charge/discharge control section of the activation process for each sample value (data point) in the time-series data of the charge/discharge profile acquired by monitoring the battery parameters of the battery cell during the activation process. Accordingly, even in case that the charging/discharging equipment does not have a segmentation function or fails the segmentation function (an error occurs), it is possible to segment the entire charge/discharge profile according to the sequence of the charge/discharge control sections of the activation process, thereby enhancing the efficiency of feature extraction and diagnosis and analysis for the battery cell.

The effects of the present disclosure are not limited to the above-mentioned effects, and these and other effects will be clearly understood by those skilled in the art from the appended claims.

### DESCRIPTION OF DRAWINGS

The accompanying drawings illustrate an exemplary embodiment of the present disclosure, and together with the following detailed description of the present disclosure, serve to provide a further understanding of the technical aspects of the present disclosure, and thus the present disclosure should not be construed as being limited to the drawings.
FIG. 1 is a schematic diagram exemplarily showing the architecture of a battery activation system according to an embodiment of the present disclosure.
FIG. 2 is a graph exemplarily showing a relationship between a charge/discharge profile that can be acquired from a battery cell during an activation process and charge/discharge control sections of the activation process.
FIG. 3 is a flowchart exemplarily showing a method for training a machine learning model.
FIG. 4 is a diagram referenced in describing a decision tree as an example of a machine learning model trained by the method of FIG. 3.
FIGS. 5 to 8 show the segmentation results of a target charge/discharge profile acquired from a trained machine learning model.
FIG. 9 is a flowchart exemplarily showing a battery charge/discharge profile analysis method according to an embodiment of the present disclosure.

### BEST MODE

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, but rather interpreted based on the meanings and concepts corresponding to the technical aspects of the present disclosure on the basis of the principle that the inventor is allowed to define the terms appropriately for the best explanation.

Therefore, the embodiments described herein and the illustrations shown in the drawings are just an exemplary embodiment of the present disclosure, but not intended to fully describe the technical aspects of the present disclosure, so it should be understood that a variety of other equivalents and modifications could have been made thereto at the time that the application was filed.

The terms including the ordinal number such as "first", "second" and the like, are used to distinguish one element from another among various elements, but not intended to limit the elements.

Unless the context clearly indicates otherwise, it will be understood that the term "comprises" when used in this specification, specifies the presence of stated elements, but does not preclude the presence or addition of one or more other elements. Additionally, the term "unit" as used herein refers to a processing unit of at least one function or operation, and may be implemented in hardware and software either alone or in combination.

In addition, throughout the specification, it will be further understood that when an element is referred to as being "connected to" another element, it can be directly connected to the other element or intervening elements may be present.

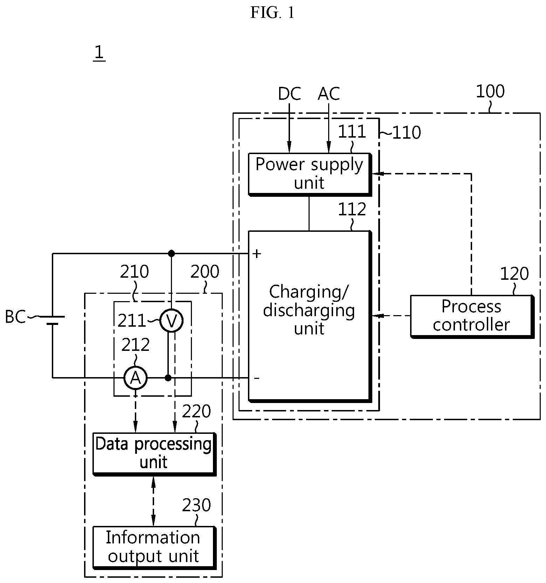

FIG. 1 is a schematic diagram exemplarily showing the architecture of a battery activation system 1 according to an embodiment of the present disclosure.

Referring to FIG. 1, the battery activation system 1 includes a charging/discharging equipment 100 and a battery charge/discharge profile analysis apparatus 200.

For an activation process of a battery cell BC assembled through a production line, the charging/discharging equipment 100 is provided to perform a series of charge/discharge control sections included in the activation process in a sequential order according to a preset activation schedule.

The charging/discharging equipment 100 has a charge function, a discharge function and a rest function, and is configured to selectively perform one of the charge function, the discharge function and the rest function according to the activation schedule, and charge and discharge the battery cell BC based on the preset control parameters (for example, the charge voltage, the charge current, the discharge voltage, the discharge current, etc.) for each charge/discharge control section. The battery cell BC is not limited to a particular type, and may include any battery cell that can be repeatedly recharged, such as a lithium ion cell.

The charging/discharging equipment 100 includes a charger/discharger 110 and a process controller 120.

The charger/discharger 110 includes a power supply unit 111 and a charging/discharging unit 112.

The power supply unit 111 is configured to convert power supplied from an alternating current power source and/or a direct current power source to a direct current having a predetermined voltage level suitable for the input specification of the charging/discharging unit 112. The power supply unit 111 may include at least one of an AC-DC converter or a DC-DC converter.

The charging/discharging unit 112 may include a pair of charge/discharge terminals which are connected to positive and negative electrodes of the battery cell BC, and may charge or discharge the battery cell BC or stop charging and discharging in response to a command from the process controller 120. The charging/discharging unit 112 may include at least one of a constant current circuit or a constant voltage circuit.

The process controller 120 pre-records the activation schedule in memory embedded therein. In response to a user input, the process controller 120 starts the activation process according to the activation schedule, and controls the charger/discharger 110 to perform each charge/discharge control section of the activation process in a sequential order according to a preset sequence.

The battery charge/discharge profile analysis apparatus 200 includes a data acquisition unit 210 and a data processing unit 220. The battery charge/discharge profile analysis apparatus 200 may further include an information output unit 230. The operation of the battery charge/discharge profile analysis apparatus 200 may be activated in response to the start of the activation process by the charging/discharging equipment 100.

The data acquisition unit 210 is configured to periodically detect a sample value of each battery parameter at a predetermined time interval during the activation process of the battery cell BC. The battery parameters include the voltage and current of the battery cell BC, and the data acquisition unit 210 includes a voltage detector 211 and a current detector 212.

The voltage detector 211 is connected to the positive and negative electrodes of the battery cell BC to detect a voltage across the battery cell BC and generate (output) a signal indicating the sample value of the detected voltage.

The current detector 212 is installed at a charge/discharge path connecting the battery cell BC to the charging/discharging unit 112 to detect a charge/discharge current flowing through the battery cell BC during the activation process and generate (output) a signal indicating the sample value of the detected current. For example, the current detector 212 may include the known current detection device such as a shunt resistor and/or a hall sensor. The voltage detector 211 and the current detector 212 may be integrated into a single chip.

The information output unit 230 is provided to output various information related to the activation process into a recognizable format for the user. In an example, the information output unit 230 may include a monitor, a touch screen, a speaker and/or a vibrator.

The data processing unit 220 is operably coupled to the data acquisition unit 210, the information output unit 230 and the charging/discharging equipment 100. Operably coupled refers to being directly/indirectly connected to transmit and receive a signal in one or two directions.

The data processing unit 220 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing the other functions.

The data processing unit 220 may have memory embedded therein. The memory may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory may store data and programs required for the following operations by the data processing unit 220. The memory may store data indicating the results of the operations performed by the data processing unit 220.

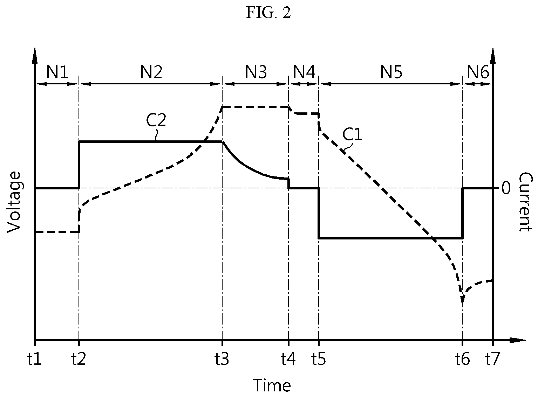

FIG. 2 is a graph exemplarily showing a relationship between the charge/discharge profile that can be acquired from the battery cell during the activation process and the charge/discharge control sections of the activation process.

Referring to FIG. 2, the charge/discharge profile includes time-series voltage data and time-series current data.

A curve C1 shows time-series voltage data. The time-series voltage data is a set of the sample values of the voltage across the battery cell BC periodically detected during the activation process, arranged according to the time index of the detection time.

A curve C2 shows time-series current data. The time-series current data is a set of the sample values of the charge/discharge current of the battery cell BC periodically detected during the activation process, arranged according to the time index of the detection time.

FIG. 2 shows that a total of 6 charge/discharge control sections, i.e., first to sixth charge/discharge control sections N1~N6 are performed in a sequential order from start to end of the activation process by way of illustration.

The first charge/discharge control section N1 is a stand-by section before charging, and before performing the second charge/discharge control section N2 for the assembled battery cell BC, for electrical and chemical internal stabilization of the battery cell BC, the battery cell BC is left alone without charging/discharging for a predetermined first rest time. In the first charge/discharge control section N1, the voltage of the battery is constantly maintained, and the current of the battery is also constant at 0 A.

The second charge/discharge control section N2 is a section in which the battery cell BC is charged with a constant current by the charger/discharger 110, starting immediately after the end of the first charge/discharge control section N1. The second charge/discharge control section N2 may end in response to the voltage of the battery cell BC reaching a predetermined cutoff voltage or the passage of a predetermined time from the start time of the second charge/discharge control section N2. In the second charge/discharge control section N2, the voltage of the battery cell BC continuously increases, and the charge current of the battery cell BC is constant at a preset current rate.

The third charge/discharge control section N3 is a section in which the battery cell BC is charged with a constant voltage by the charger/discharger 110, starting immediately after the end of the second charge/discharge control section N2. The voltage level of the constant current charging may be equal to the cutoff voltage at the second charge/discharge control section N2. The third charge/discharge control section N3 may end in response to the charge current of the battery cell BC reaching a predetermined cutoff current or the passage of a predetermined time from the start time of the third charge/discharge control section N3. In the third charge/discharge control section N3, the voltage of the battery cell BC increases more slowly than the second charge/discharge control section N2. In the third charge/discharge control section N3, a difference between the voltage level of the constant voltage charging and the voltage of the battery cell BC gradually decreases, and the charge current of the battery cell BC spontaneously decreases toward 0 A.

The fourth charge/discharge control section N4 is a stand-by section after charging, and to mitigate polarization by the charging over the second and third charge/discharge control sections, the battery cell BC is left alone without charging/discharging for a predetermined second rest time. In the fourth charge/discharge control section N4, the voltage of the battery cell BC gently drops to a little bit lower voltage from the cutoff voltage to gradually stabilize the voltage, and the current of the battery cell BC is constant at 0 A in the same way as the first charge/discharge control section N1.

The fifth charge/discharge control section N5 is a section in which the battery cell BC is discharged with a constant current by the charger/discharger 110, starting immediately after the end of the fourth charge/discharge control section N4. The fifth charge/discharge control section N5 may end in response to the voltage of the battery cell BC reaching a predetermined end-of-discharge voltage or the passage of a predetermined time from the start time of the fifth charge/discharge control section N5. In the fifth charge/discharge control section N5, the voltage of the battery cell BC continuously drops, and the discharge current of the battery cell BC is constant at a preset current rate.

The sixth charge/discharge control section N6 is a stand-by section after discharging, and to mitigate polarization by the discharging over the fifth charge/discharge control section N5, the battery cell BC is left alone without charging/discharging for a predetermined third rest time. At the start time of the sixth charge/discharge control section N6, the voltage of the battery cell BC is recovered from the end-of-discharge voltage by the voltage drop calculated by multiplying the current rate of the constant current discharging by the internal resistance of the battery cell BC and then gradually stabilized, and the current of the battery cell BC is constant at 0 A in the same way as the first and fourth charge/discharge control sections N1, N4.

It should be noted that in each of the first to sixth charge/discharge control sections N1~N6, the sample values of the battery parameters that are uniquely distinguished from each of the remaining charge/discharge control sections are acquired. In an example, the fifth charge/discharge control section N5 is distinguished from the remaining charge/discharge control sections since it is a section in which the discharge current flows through the battery cell BC. In another example, the first, fourth and sixth charge/discharge control sections are distinguished from the second, third and fifth charge/discharge control sections in that the current is 0 A. Additionally, the first, fourth and sixth charge/discharge control sections are common in the current of 0 A, but the voltage of the battery cell BC in the three sections respectively is disposed at three voltage ranges that do not overlap.

Since the sample values of the battery parameters having the unique features that can be distinguished from different charge/discharge control sections are acquired in each charge/discharge control section of the activation process, the battery charge/discharge profile analysis apparatus 200 may provide a segmentation function of post-assigning section classification information to the charge/discharge profile after the end of the activation process through the operation of allocating an identification number of the charge/discharge control section designated by the sample value of one battery parameter or a combination of the sample values of two or more battery parameters arranged by the time index of the charge/discharge profile to associate it with the time index of the corresponding sample value (or the combination of the sample values of the two battery parameters). The identification numbers may have an ascending or descending relationship according to the sequence of the charge/discharge control sections. In an example, the identification number (for example, N1) of the previous charge/discharge control section may be smaller than the identification number of the subsequent charge/discharge control section (for example, N2). FIG. 2 shows that a difference between the two identification numbers of the two adjacent charge/discharge control sections is 1 by way of illustration. Hereinafter, for convenience of description, the same symbol is affixed to each charge/discharge control section and its identification number.

The section classification information is a dataset of identification numbers arranged according to the time indexes disposed in the time range of from the start time of the activation process to the end time. The battery charge/discharge profile analysis apparatus 200 may activate the segmentation function by executing a machine learning model trained using a plurality of training charge/discharge profiles as a training dataset. Each training charge/discharge profile includes training section classification information, and the training section classification information is a dataset in which the identification number of any one of the plurality of charge/discharge control sections performed in a sequential order in the activation process is allocated to each time index. The training section classification information may be manually inputted by the user.

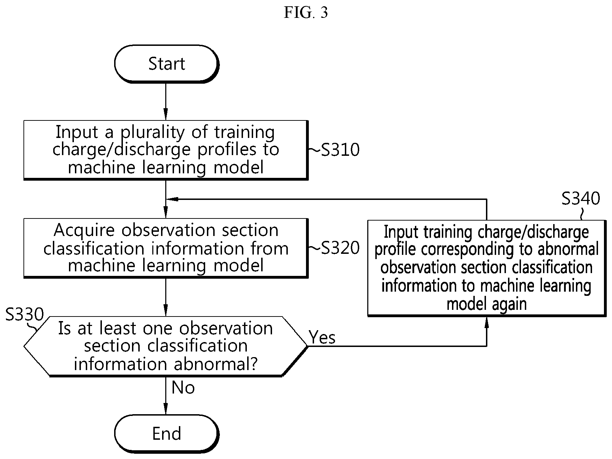

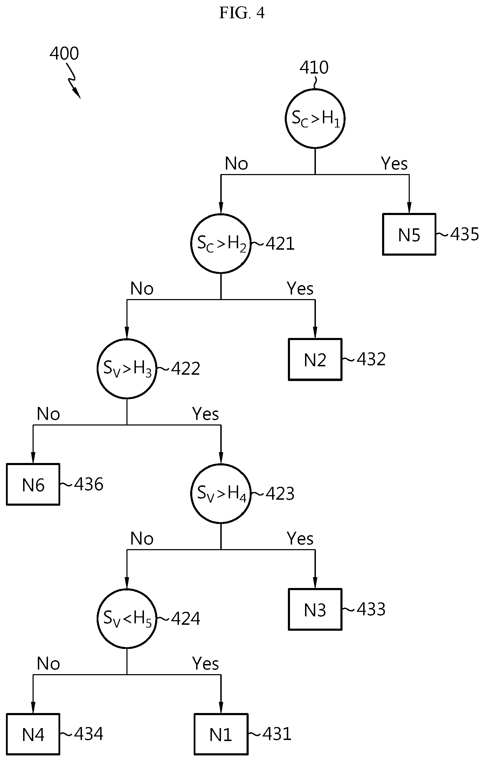

FIG. 3 is a flowchart exemplarily showing a method for training the machine learning model, and FIG. 4 is a diagram referenced in describing a decision tree as an example of the trained machine learning model according to the method of FIG. 3. The method of FIG. 3 may be performed by the battery charge/discharge profile analysis apparatus 200. Any other model capable of multiclassification than the decision tree may be applied as the machine learning model.

Referring to FIGS. 3 and 4, in step S310, the data processing unit 220 inputs the plurality of training charge/discharge profiles to the machine learning model 400.

In step S320, the data processing unit 220 acquires observation section classification information corresponding to each input training charge/discharge profile from the machine learning model 400. Each observation section classification information is a time-series of identification numbers assigned to a dataset classified by the machine learning model 400, i.e., time indexes of each training charge/discharge profile.

In step S330, the data processing unit 220 determines if at least one observation section classification information is abnormal by comparing the observation section classification information with the corresponding training section classification information. A value of the step S330 being "No" indicates that training is completed due to the impurity of the machine learning model less than a reference value. The value of the step S330 being "Yes" indicates that additional training is necessary due to the impurity of the machine learning model equal to or larger than the reference value. When the value of the step S330 is "Yes", step S340 is performed.

In the step S340, the data processing unit 220 inputs the training charge/discharge profile corresponding to the abnormal observation section classification information among the plurality of training charge/discharge profiles to the machine learning model 400 again.

FIG. 4 shows the decision tree 400 trained for the first to sixth charge/discharge control sections N1~N6. The decision tree 400 includes a root node 410, first to fourth intermediate nodes 421~424 and first to sixth terminal nodes. The root node 410 and the intermediate node may be referred collectively to as an internal node, and the internal node has a unique classification condition. The first to sixth terminal nodes 431~436 are associated with the identification numbers of the first to sixth charge/discharge control sections N1~N6 as a result of classifying data for each time index (voltage sample value + current sample value), respectively.

The root node 410 is a node that provides a stronger classification condition than the first to fourth intermediate nodes 421~424. In FIG. 4, to classify into the fifth charge/discharge control section N5 and the remaining charge/discharge control sections, in the root node 410, the current sample value S_{C} for each time index is compared with a discharge current value H₁ associated with the fifth charge/discharge control section N5. The discharge current value H₁ is set through the above-described training process. The identification number N5 associated with the fifth terminal node 435 is allocated to the data for each time index satisfying the classification condition of the root node 410. The data for each time index not satisfying the classification condition of the root node 410 is input to the first intermediate node 421.

The first intermediate node 421 is a node that provides a stronger classification condition than the second to fourth intermediate nodes 422~424. In FIG. 4, to classify into the second charge/discharge control section N2 and the remaining charge/discharge control sections, in the first intermediate node 421, the current sample value S_{C} for each time index is compared with a charge current value H₂ associated with the second charge/discharge control section N2. The charge current value H₂ is set through the above-described training process. The identification number N2 associated with the second terminal node 432 is allocated to the data for each time index satisfying the classification condition of the first intermediate node 421. The data for each time index not satisfying the classification condition of the first intermediate node 421 is input to the second intermediate node 422.

The second intermediate node 422 is a node that provides a stronger classification condition than the third and fourth intermediate nodes 423, 424. In FIG. 4, to classify into the sixth charge/discharge control section N6 and the remaining charge/discharge control sections, in the second intermediate node 422, the voltage sample value S_{V} for each time index is compared with a voltage value H₃ associated with the sixth charge/discharge control section N6. The voltage value H₃ associated with the sixth charge/discharge control section N6 is set through the above-described training process. The identification number N6 associated with the sixth terminal node 436 is allocated to the data for each time index satisfying the classification condition of the second intermediate node 422. The data for each time index not satisfying the classification condition of the second intermediate node 422 is input to the third intermediate node 423.

The third intermediate node 423 is a node that provides a stronger classification condition than the fourth intermediate node 424. In FIG. 4, to classify into the third charge/discharge control section N3 and the remaining charge/discharge control sections, in the third intermediate node 423, the voltage sample value S_{V} for each time index is compared with the voltage value H₄ associated with the third charge/discharge control section N3. The voltage value H₄ associated with the third charge/discharge control section N3 is set through the above-described training process. The identification number N3 associated with the third terminal node 433 is allocated to the data for each time index satisfying the classification condition of the third intermediate node 423. The data for each time index not satisfying the classification condition of the third intermediate node 423 is input to the fourth intermediate node 424.

The fourth intermediate node 424 is a node that provides the last classification condition. In FIG. 4, to classify into the first charge/discharge control section N1 and the fourth charge/discharge control section N4, in the fourth intermediate node 424, the voltage sample value S_{V} for each time index is compared with a voltage value H₅ associated with the first charge/discharge control section N1. The voltage value H₅ associated with the first charge/discharge control section N1 is set through the above-described training process. The identification number N1 associated with the first terminal node 431 is allocated to the data for each time index satisfying the classification condition of the fourth intermediate node 424. The identification number N4 associated with the fourth terminal node 434 is allocated to the data for each time index not satisfying the classification condition of the fourth intermediate node 424.

The data processing unit 220 may assign target section classification information to a target charge/discharge profile by inputting the target charge/discharge profile to the trained machine learning model 400. The target charge/discharge profile refers to a charge/discharge profile acquired through the actual activation process of the assembled battery cell BC. The target section classification information refers to section classification information assigned to the target charge/discharge profile.

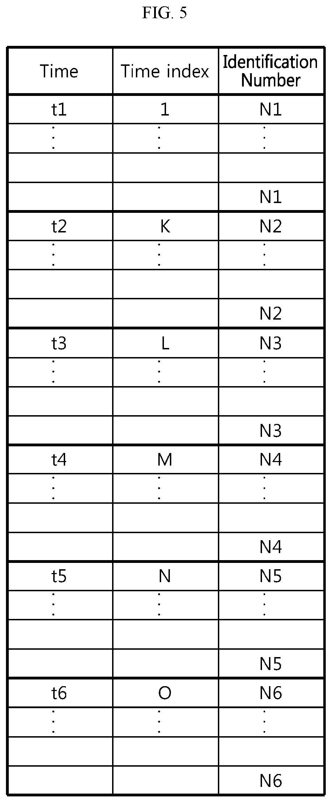

FIGS. 5 to 8 shows the segmentation results of the target charge/discharge profile acquired from the trained machine learning model 400. The data processing unit 220 may determine if the target charge/discharge profile is abnormal by comparing the identification numbers allocated to the time indexes of the target section classification information according to the sequence of the time indexes of the target section classification information. In FIGS. 5 to 8, the symbols K, L, M, N and O used from the time indexes denote natural numbers in a relationship of 1 < K < L < M < N < O.

To begin with, FIG. 5 shows an example of normal target section classification information assigned to the target charge/discharge profile. Referring to FIG. 3, the identification number of the first charge/discharge control section N1 is allocated to each time index from time t1 until time t2, the identification number of the second charge/discharge control section N2 is allocated to each time index from time t2 until time t3, the identification number of the third charge/discharge control section N3 is allocated to each time index from time t3 until time t4, the identification number of the fourth charge/discharge control section N4 is allocated to each time index from time t4 until time t5, the identification number of the fifth charge/discharge control section N5 is allocated to each time index from time t5 until time t6, and the identification number of the sixth charge/discharge control section N6 is allocated to each time index from time t6 until time t7.

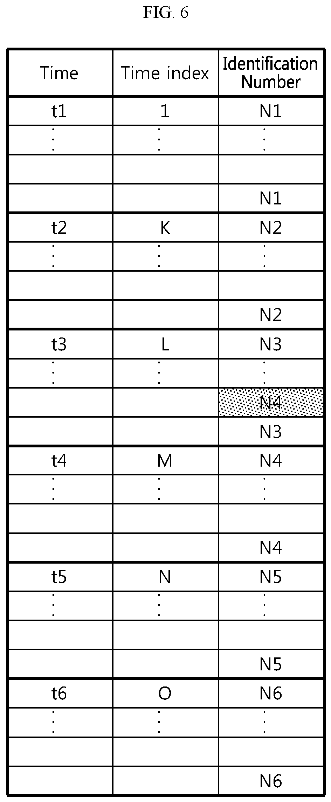

Subsequently, FIG. 6 shows an example of abnormal target section classification information assigned to the target charge/discharge profile. Referring to FIG. 6, when comparing with FIG. 5, the identification number of the fourth charge/discharge control section N4 performed after the third charge/discharge control section N3 is allocated to at least one of the time indexes from time t3 until time t4. As shown in FIG. 6, when the identification number (for example, N4) allocated to the previous time index (for example, M-2) is larger than the identification number (for example, N3) allocated to the subsequent time index (for example, M-1) among any two time indexes of the target section classification information, the data processing unit 220 may determine that the target charge/discharge profile is abnormal.

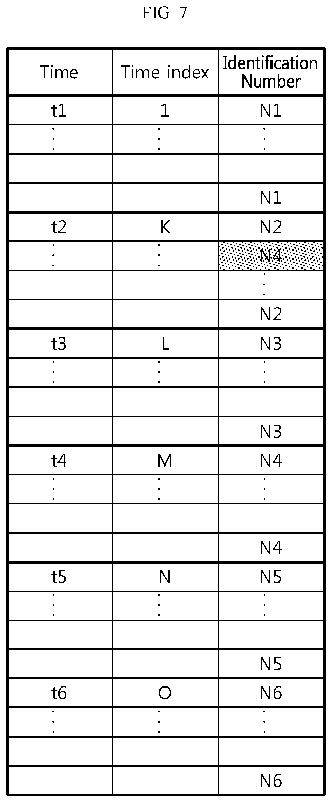

Subsequently, FIG. 7 shows another example of abnormal target section classification information assigned to the target charge/discharge profile. Referring to FIG. 7, when comparing with FIG. 5, the identification number of the first charge/discharge control section N1 is normally allocated to the time indexes from time t1 until time t2, while the identification number of the fourth charge/discharge control section N4, not the second charge/discharge control section N2, is allocated to some time indexes between time t2 and time t3. As shown in FIG. 7, when there is an identification number (for example, N3) having a value between two identification numbers (for example, N2, N4) allocated to any two adjacent time indexes (for example, K, K + 1) of the target section classification information, the data processing unit 220 may determine that the target charge/discharge profile is abnormal.

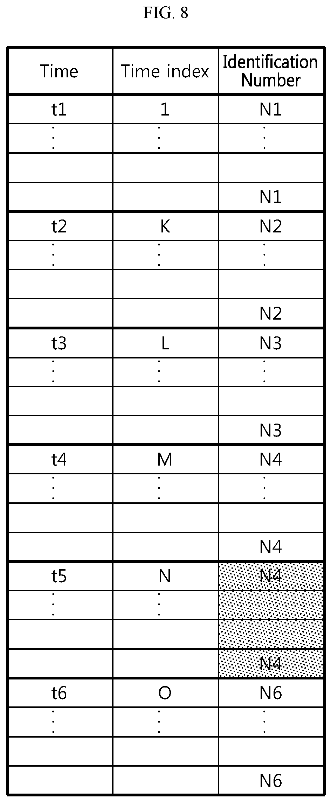

Subsequently, FIG. 8 shows still another example of abnormal target section classification information assigned to the target charge/discharge profile. Referring to FIG. 8, when comparing with FIG. 5, the identification number of the fourth charge/discharge control section N4 is allocated to all the time indexes from time t5 until time t6. As shown in FIG. 8, when the identification number (for example, N5) of at least one of the plurality of charge/discharge control sections N1~N6 is allocated to none of the time indexes of the target section classification information, the data processing unit 220 may determine that the target charge/discharge profile is abnormal.

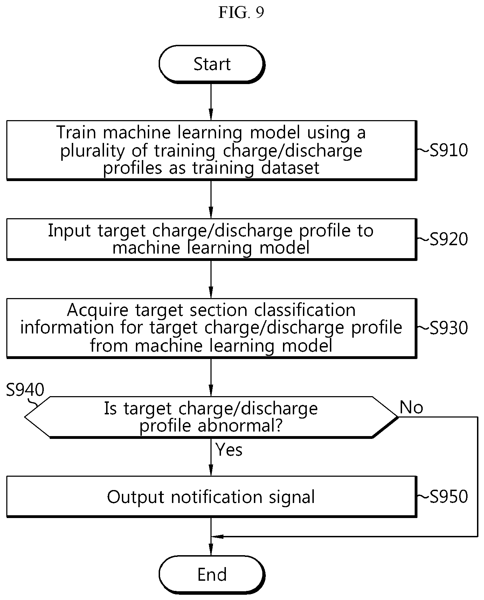

FIG. 9 is a flowchart exemplarily showing a battery charge/discharge profile analysis method according to an embodiment of the present disclosure.

Referring to FIG. 9, in step S910, the data processing unit 220 trains the machine learning model 400 using the plurality of training charge/discharge profiles stored in the data acquisition unit 210 as a training dataset (see FIGS. 3 and 4).

In step S920, the data processing unit 220 inputs the target charge/discharge profile acquired through the activation process of the battery cell BC to the machine learning model 400.

In step S930, the data processing unit 220 acquires the target section classification information for the input target charge/discharge profile from the machine learning model 400. The target section classification information may be recorded in the memory or transmitted to the user through the information output unit 230.

The method of FIG. 9 may further include step S940. In step S940, the data processing unit 220 determines if the target charge/discharge profile is abnormal by comparing the identification numbers allocated to the time indexes of the target section classification information according to the sequence of the time indexes of the target section classification information (see FIGS. 5 to 8). When a value of the step S940 is "Yes", step S950 may be performed.

**In** the step S950, the data processing unit 220 may output a notification signal including at least one of (i) the abnormality type of the target section classification information or (i) the time index to which the identification number is incorrectly allocated. The notification signal may be recorded in the memory or transmitted to the user through the information output unit 230.

The embodiments of the present disclosure described hereinabove are not implemented only through the apparatus and method, and may be implemented through programs that perform the functions corresponding to the configurations of the embodiments of the present disclosure or recording media having the programs recorded thereon, and such implementation may be easily achieved by those skilled in the art from the disclosure of the embodiments described above.

While the present disclosure has been hereinabove described with regard to a limited number of embodiments and drawings, the present disclosure is not limited thereto and it is obvious to those skilled in the art that various modifications and changes may be made thereto within the technical aspects of the present disclosure and the appended claims and their equivalents.

Additionally, as many substitutions, modifications and changes may be made to the present disclosure described hereinabove by those skilled in the art without departing from the technical aspects of the present disclosure, the present disclosure is not limited by the above-described embodiments and the accompanying drawings, and all or some of the embodiments may be selectively combined to allow various modifications.

### (Description of Reference Numerals)

| | | | |
|---|---|---|---|
| 1: | Battery activation system | BC: | Battery cell |
| 100: | Charging/discharging equipment | 110: | Charger/discharger |
| 111: | Power supply unit | 112: | Charging/discharging unit |
| 120: | Controller | | |
| 200: | Battery charge/discharge profile analysis apparatus | | |
| 210: | Data acquisition unit | 211: | Voltage detector |
| 212: | Current detector | | |
| 220: | Data processing unit | 230: | Information output unit |

## Claims

1. A battery charge/discharge profile analysis method, comprising:
training (S910) a machine learning model (400) using a plurality of training charge/discharge profiles as a training dataset, wherein each training charge/discharge profile includes training section classification information, and the training section classification information is a dataset in which an identification number of any one of a plurality of charge/discharge control sections (N1-N6) performed in a sequential order in an activation process is allocated to each time index;
inputting (S920) a target charge/discharge profile acquired through the activation process of a battery cell (BC) to the machine learning model (400), wherein the target charge/discharge profile includes time-series voltage data (SV) indicating a time-dependent change of a voltage of the battery cell (BC) according to the time indexes of the target charge/discharge profile, and time-series current data (SC) indicating a time-dependent change of a charge/discharge current of the battery cell (BC) according to the time indexes of the target charge/discharge profile;
acquiring (S930) target section classification information for the input target charge/discharge profile from the machine learning model (400), wherein the target section classification information is a dataset in which the identification number of any one of the plurality of charge/discharge control sections (N1-N6) is allocated to each time index of the target charge/discharge profile; and
determining (S940) if the target charge/discharge profile is abnormal by comparing the identification numbers allocated to the time indexes of the target section classification information according to a sequence of the time indexes of the target section classification information.

2. The battery charge/discharge profile analysis method according to claim 1, wherein the machine learning model (400) is a decision tree.

3. The battery charge/discharge profile analysis method according to claim 1, wherein the identification number of a previous charge/discharge control section is smaller than the identification number of a subsequent charge/discharge control section among any two of the plurality of charge/discharge control sections (N1-N6).

4. The battery charge/discharge profile analysis method according to claim 3, wherein when the identification number allocated to the previous time index is larger than the identification number allocated to the subsequent time index among any two time indexes of the target section classification information, the target charge/discharge profile is determined to be abnormal.

5. The battery charge/discharge profile analysis method according to claim 1, wherein when any of the plurality of identification numbers of the plurality of charge/discharge control sections (N1-N6) has a value between two identification numbers allocated to any two adjacent time indexes of the target section classification information, the target charge/discharge profile is determined to be abnormal.

6. The battery charge/discharge profile analysis method according to claim 1, wherein when the identification number of at least one of the plurality of charge/discharge control sections (N1-N6) is allocated to none of the time indexes of the target section classification information, the target charge/discharge profile is determined to be abnormal.

7. A battery charge/discharge profile analysis apparatus (200), comprising:
a data acquisition unit (210) configured to store a plurality of training charge/discharge profiles, wherein each training charge/discharge profile includes training section classification information and the training section classification information is a dataset in which an identification number of any one of a plurality of charge/discharge control sections (N1-N6) performed in a sequential order in an activation process is allocated to each time index; and
a data processing unit (220) configured to
train (S910) a machine learning model (400) using the plurality of training charge/discharge profiles as a training dataset,
wherein the data processing unit (220) is configured to
input (S920) a target charge/discharge profile acquired through the activation process of a battery cell (BC) to the machine learning model (400), wherein the target charge/discharge profile includes time-series voltage data (SV) indicating a time-dependent change of a voltage of the battery cell (BC) according to the time indexes of the target charge/discharge profile, and time-series current data (SC) indicating a time-dependent change of a charge/discharge current of the battery cell (BC) according to the time indexes of the target charge/discharge profile;
acquire (S930) target section classification information for the input target charge/discharge profile from the machine learning model (400), wherein the target section classification information is a dataset in which the identification number of any one of the plurality of charge/discharge control sections (N1-N6) is allocated to each of the time indexes of the target charge/discharge profile; and
determine (S940) if the target charge/discharge profile is abnormal by comparing the identification numbers allocated to the time indexes of the target section classification information according to a sequence of the time indexes of the target section classification information.

8. The battery charge/discharge profile analysis apparatus (200) according to claim 7, wherein the machine learning model (400) is a decision tree.

9. A battery activation system (1) comprising the battery charge/discharge profile analysis apparatus (200) according to any one of claims 7 to 8.

## Patentansprüche

1. Batterieladungs-/-entladungsprofil-Analyseverfahren umfassend:
Trainieren (S910) eines Maschinenlernmodells (400) unter Verwendung von mehreren Trainingsladungs-/-entladungsprofilen als ein Trainingsdatensatz, wobei jedes Trainingsladungs-/-entladungsprofil Trainingsabschnitt-Klassifizierungsinformationen enthält und die Trainingsabschnitt-Klassifizierungsinformationen ein Datensatz sind, in dem eine Identifikationsnummer eines beliebigen aus mehreren Ladungs-/- entladungssteuerabschnitten (N1-N6), die in einer sequentiellen Reihenfolge in einem Aktivierungsprozess durchgeführt werden, jedem Zeitindex zugewiesen wird;
Eingeben (S920) eines Zielladungs-/-entladungsprofils, das durch den Aktivierungsprozess einer Batteriezelle (BC) erfasst wird, in das Maschinenlernmodell (400), wobei das Zielladungs-/-entladungsprofil Zeitreihenspannungsdaten (SV), die eine zeitabhängige Änderung einer Spannung der Batteriezelle (BC) gemäß den Zeitindizes des Zielladungs-/- entladungsprofils angeben, und Zeitreihenstromdaten (SC), die eine zeitabhängige Änderung eines Ladungs-/Entladungsstroms der Batteriezelle (BC) gemäß den Zeitindizes des Zielladungs-/-entladungsprofils angeben, enthält;
Erfassen (S930) von Zielabschnitt-Klassifizierungsinformationen für das eingegebene Zielladungs-/-entladungsprofil aus dem Maschinenlernmodell (400), wobei die Zielabschnitt-Klassifizierungsinformationen ein Datensatz sind, in dem die Identifikationsnummer eines beliebigen aus den mehreren Ladungs-/-entladungssteuerabschnitten (N1-N6) jedem Zeitindex des Zielladungs-/-entladungsprofils zugewiesen wird; und
Bestimmen (S940), ob das Zielladungs-/-entladungsprofil anormal ist, durch Vergleichen der Identifikationsnummern, die den Zeitindizes der Zielabschnitt-Klassifizierungsinformationen zugewiesen sind, gemäß einer Sequenz der Zeitindizes der Zielabschnitt-Klassifizierungsinformationen.

2. Batterieladungs-/-entladungsprofil-Analyseverfahren nach Anspruch 1, wobei das Maschinenlernmodell (400) ein Entscheidungsbaum ist.

3. Batterieladungs-/-entladungsprofil-Analyseverfahren nach Anspruch 1, wobei die Identifikationsnummer eines vorhergehenden Ladungs-/-entladungssteuerabschnitts kleiner ist als die Identifikationsnummer eines nachfolgenden Ladungs-/-entladungssteuerabschnitts unter zwei beliebigen aus den mehreren Ladungs-/-entladungssteuerabschnitten (N1-N6).

4. Batterieladungs-/-entladungsprofil-Analyseverfahren nach Anspruch 3, wobei, wenn die Identifikationsnummer, die dem vorhergehenden Zeitindex zugewiesen ist, größer ist als die Identifikationsnummer, die dem nachfolgenden Zeitindex unter zwei beliebigen Zeitindizes der Zielabschnitt-Klassifizierungsinformationen zugewiesen ist, bestimmt wird, dass das Zielladungs-/-entladungsprofil anormal ist.

5. Batterieladungs-/-entladungsprofil-Analyseverfahren nach Anspruch 1, wobei, wenn eine beliebige aus den mehreren Identifikationsnummern der mehreren Ladungs-/- entladungssteuerabschnitte (N1-N6) einen Wert zwischen zwei Identifikationsnummern aufweist, die zwei beliebigen benachbarten Zeitindizes der Zielabschnitt-Klassifizierungsinformationen zugewiesen sind, bestimmt wird, dass das Zielladungs-/- entladungsprofil anormal ist.

6. Batterieladungs-/-entladungsprofil-Analyseverfahren nach Anspruch 1, wobei, wenn die Identifikationsnummer mindestens eines aus den mehreren Ladungs-/- entladungssteuerabschnitten (N1-N6) keinem der Zeitindizes der Zielabschnitt-Klassifizierungsinformationen zugewiesen ist, bestimmt wird, dass das Zielladungs-/- entladungsprofil anormal ist.

7. Batterieladungs-/-entladungsprofil-Analysevorrichtung (200) umfassend:
eine Datenerfassungseinheit (210), die konfiguriert ist, mehrere Trainingsladungs-/- entladungsprofile zu speichern, wobei jedes Trainingsladungs-/-entladungsprofil Trainingsabschnitt-Klassifizierungsinformationen enthält und die Trainingsabschnitt-Klassifizierungsinformationen ein Datensatz sind, in dem eine Identifikationsnummer eines beliebigen aus mehreren Ladungs-/-entladungssteuerabschnitten (N1-N6), die in einer sequentiellen Reihenfolge in einem Aktivierungsprozess durchgeführt werden, jedem Zeitindex zugewiesen wird; und
eine Datenverarbeitungseinheit (220), die konfiguriert ist,
ein Maschinenlernmodell (400) unter Verwendung der mehreren Trainingsladungs-/- entladungsprofile als ein Trainingsdatensatz zu trainieren (S910),
wobei die Datenverarbeitungseinheit (220) konfiguriert ist,
ein Zielladungs-/-entladungsprofil, das durch den Aktivierungsprozess einer Batteriezelle (BC) erfasst wird, in das Maschinenlernmodell (400) einzugeben (S920), wobei das Zielladungs-/-entladungsprofil Zeitreihenspannungsdaten (SV), die eine zeitabhängige Änderung einer Spannung der Batteriezelle (BC) gemäß den Zeitindizes des Zielladungs-/- entladungsprofils angeben, und Zeitreihenstromdaten (SC), die eine zeitabhängige Änderung eines Ladungs-/Entladungsstroms der Batteriezelle (BC) gemäß den Zeitindizes des Zielladungs-/-entladungsprofils angeben, enthält;
Zielabschnitt-Klassifizierungsinformationen für das eingegebene Zielladungs-/- entladungsprofil aus dem Maschinenlernmodell (400) zu erfassen (S930), wobei die Zielabschnitt-Klassifizierungsinformationen ein Datensatz sind, in dem die Identifikationsnummer eines beliebigen aus den mehreren Ladungs-/- entladungssteuerabschnitten (N1-N6) jedem der Zeitindizes des Zielladungs-/- entladungsprofils zugewiesen wird; und
zu bestimmen (S940), ob das Zielladungs-/-entladungsprofil anormal ist, durch Vergleichen der Identifikationsnummern, die den Zeitindizes der Zielabschnitt-Klassifizierungsinformationen zugewiesen sind, gemäß einer Sequenz der Zeitindizes der Zielabschnitt-Klassifizierungsinformationen.

8. Batterieladungs-/-entladungsprofil-Analysevorrichtung (200) nach Anspruch 7, wobei das Maschinenlernmodell (400) ein Entscheidungsbaum ist.

9. Batterieaktivierungssystem (1) umfassend die Batterieladungs-/-entladungsprofil-Analysevorrichtung (200) nach einem der Ansprüche 7 bis 8.

## Revendications

1. Procédé d'analyse du profil de charges/décharges d'une batterie, comprenant :
former (S910) un modèle d'apprentissage automatique (400) utilisant une pluralité de profils de charges/décharges de formation sous forme d'un jeu de données d'apprentissage, chaque profil de charges/décharges de formation comprenant des informations de classification par section de formation, et les informations de classification de section de formation étant un jeu de données dans lequel un numéro d'identification d'une quelconque d'une pluralité de sections de contrôle des charges/décharges (N1-N6) effectuées dans un ordre séquentiel dans un processus d'activation est attribué à chaque indice temporel ;
entrer (S920) un profil de charges/décharges cible acquis par le biais du processus d'activation d'une cellule de batterie (BC) dans le modèle d'apprentissage automatique (400), le profil de charges/décharges cible comprenant des données de tension en série temporelle (SV) indiquant une variation temporelle d'une tension de la cellule de batterie (BC) selon les indices temporels du profil de charges/décharges cible, et des données de courant en série temporelle (SC) indiquant une variation temporelle d'un courant de charges/décharges de la cellule de batterie (BC) selon les indices temporels du profil de charges/décharges cible ;
saisir (S930) des informations de classification de la section cible pour le profil de charges/décharges cible d'entrée d'après le modèle d'apprentissage automatique (400), les informations de classification de la section cible étant un jeu de données dans lequel le numéro d'identification d'une quelconque de la pluralité de sections de contrôle de charges/décharges (N1-N6) est attribué à chaque indice temporel du profil de charges/décharges cible ; et
établir (S940) si le profil de charges/décharges cible est anormal en comparant les numéros d'identification attribués aux indices temporels des informations de classification de la section cible selon une séquence des indices temporels des informations de classification de la section cible.

2. Procédé d'analyse du profil de charges/décharges de la batterie selon la revendication 1, le modèle d'apprentissage automatique (400) étant un arbre décisionnel.

3. Procédé d'analyse du profil de charges/décharges de batterie selon la revendication 1, le numéro d'identification d'une section de contrôle de charges/décharges précédente étant inférieur au numéro d'identification d'une section de contrôle de charges/décharges suivant parmi deux quelconques de la pluralité de sections de contrôle de charges/décharges (N1-N6).

4. Procédé d'analyse du profil de charges/décharges de la batterie selon la revendication 3, dans lequel, lorsque le numéro d'identification attribué à l'indice de temps précédent est supérieur au numéro d'identification attribué à l'indice de temps suivant, parmi deux indices quelconques des informations de classification de la section cible, le profil de charges/décharges cible est considéré comme étant anormal.

5. Procédé d'analyse du profil de charges/décharges de la batterie selon la revendication 1, dans lequel, lorsque la valeur d'un quelconque de la pluralité de numéros d'identification de la pluralité de sections de contrôle de charges/décharges (N1-N6) est comprise entre deux numéros d'identification attribués à toute paire d'indices temporels adjacents des informations de classification de la section cible, le profil de charges/décharges cible est considéré comme étant anormal.

6. Procédé d'analyse du profil de charges/décharges de la batterie selon la revendication 1, dans lequel, lorsque le numéro d'identification d'au moins une de la pluralité de sections de contrôle de charges/décharges (N1-N6) n'est attribué à aucun des indices temporels des informations de classification de la section cible, le profil de charges/décharges cible est considéré comme étant anormal.

7. Appareil d'analyse du profil de charges/décharges d'une batterie (200), comprenant :
un module de saisie de données (210) configuré pour stocker une pluralité de profils de charges/décharges de formation, chaque profil de charges/décharges de formation comprenant des informations de classification de sections de formation, et les informations de classification de sections de formation étant un jeu de données dans lequel un numéro d'identification d'une quelconque d'une pluralité de sections de contrôle de charges/décharges (N1-N6) effectuées dans un ordre séquentiel dans un processus d'activation est attribué à chaque indice temporel ; et
un module de traitement de données (220) configuré pour
former (S910) un modèle d'apprentissage automatique (400) en utilisant la pluralité des profils de charges/décharges de formation en tant que jeu de données de formation,
le module de traitement de données (220) étant configuré pour entrer (S920) un profil de charges/décharges cible acquis par le biais du processus d'activation d'une cellule de batterie (BC) dans le modèle d'apprentissage automatique (400), le profil de charges/décharges cible comprenant des données de tension en série temporelle (SV) indiquant une variation temporelle d'une tension de la cellule de batterie (BC) selon les indices temporels du profil de charge/décharge cible, et des données de courant en série temporelle (SC) indiquant une variation temporelle d'un courant de charges/décharges de la cellule de batterie (BC) selon les indices temporels du profil de charges/décharges cible ;
saisir (S930) des informations de classification de la section cible pour le profil de charge/décharge cible entré d'après le modèle d'apprentissage automatique (400), les informations de classification de la section cible étant un jeu de données dans lequel le numéro d'identification d'une quelconque de la pluralité de sections de contrôle de charges/décharges (N1-N6) est attribué à chacun des indices temporels du profil de charges/décharges cible ; et
établir (S940) si le profil de charges/décharges cible est anormal en comparant les numéros d'identification attribués aux indices temporels des informations de classification de la section cible selon une séquence des indices temporels des informations de classification de la section cible.

8. Procédé d'analyse du profil de charges/décharges de la batterie (200) selon la revendication 7, le modèle d'apprentissage automatique (400) étant un arbre décisionnel.

9. Système d'activation de batterie (1) comprenant l'appareil d'analyse du profil charges/décharges de la batterie (200) selon une quelconque des revendications 7 à 8.
